# EUROPEAN PATENT SPECIFICATION

(11) **EP 2 426 734 B1**
(45) Date of publication and mention of the grant of the patent: **07.11.2018**
(21) Application number: 11007197.4
(22) Date of filing: 05.09.2011
(51) Int. Cl.: H01L 31/048, B64G 1/44

(54) **Solar battery module**
Solarbatteriemodul
Module de batterie solaire

(30) Priority: 06.09.2010 JP 2010198972
(43) Date of publication of application: 07.03.2012
(73) Proprietor: Sharp Kabushiki Kaisha, Osaka-shi, Osaka 545-8522 (JP)
(72) Inventor: Yamaguchi, Hiroshi, Osaka-shi Osaka 545-8522 (JP)
(74) Representative: Müller Hoffmann & Partner

(56) References cited:
- US-A- 3 627 585
- US-A- 5 620 529

## Description

This application is based on Japanese Patent Application No. 2010-198972 filed with the Japan Patent Office on September 6, 2010.

### BACKGROUND OF THE INVENTION

### Field of the Invention

The present invention relates to a solar battery module, and particularly to a solar battery module having flexibility.

### Description of the Background Art

A solar battery module formed by connecting a plurality of solar battery cells to one another has currently been mounted on an artificial satellite. As a photoelectric conversion portion in the solar battery cell generally employed in the artificial satellite, a component fabricated by epitaxially growing a group III-V compound semiconductor such as InGaP and GaAs on a Ge substrate or a GaAs substrate having a thickness from 100 µm to 500 µm is employed as it is. Therefore, the substrate for growth still remains in the solar battery cell.

Since the solar battery cell having the substrate as above does not have flexibility, it may be broken simply by being slightly bent. Therefore, in order to prevent the solar battery cell from being broken by heavy vibration at the time of launch of an artificial satellite, a solar battery module in which solar battery cells are protected by a honeycomb plate is generally mounted on an artificial satellite (Japanese Patent Laying-Open Nos. 9-283785 and 2002-173098).

In such a conventional solar battery module, generally, a cover glass having a thickness from 50 µm to 500 µm for protecting a solar battery is bonded to a light receiving surface of the solar battery cell with the use of a transparent adhesive, and an insulating sheet, a carbon reinforced fiber plastic sheet and a honeycomb plate are stacked in this order on a back surface of the solar battery cell, with an adhesive being interposed.

The honeycomb plate functioning as a support in the solar battery cell is an assembly of innumerably continuous hexagonal cores and it has high strength. A honeycomb plate made of aluminum has currently generally been used, and it can structurally support a plurality of solar battery cells from the back surface. This structure can prevent a solar battery cell from being broken by heavy vibration at the time of launch of an artificial satellite described above.

Documents US3627585 and US5620529 both disclose space solar modules.

### SUMMARY OF THE INVENTION

The honeycomb plate above, however, normally has a thickness approximately from 1 cm to 2 cm, which imposes severe restriction on capacity of carrying a solar battery module on an artificial satellite. Namely, in order to accommodate the artificial satellite in a fairing portion in a booster rocket, the solar battery module mounted on the artificial satellite should be folded several times. A volume occupied by the honeycomb plate in the solar battery module, however, is great, and hence the carrying capacity is restricted.

Electric power consumed in the artificial satellite increases as a result of higher performance of equipment mounted on a recent artificial satellite, and increase in capacity of carrying a solar battery module for supplying electric power has been demanded. For the reasons above, however, the carrying capacity is actually restricted. In addition, in order to increase the carrying capacity, reduction in weight of the solar battery module is necessary from a technical and economical point of view.

In view of the circumstances above, an object of the present invention is to provide a solar battery module achieving reduction in size and weight.

The present invention is directed to a solar battery module including a plurality of solar battery arrays in which solar battery cells having flexibility are electrically connected to one another through interconnectors, and it includes a plurality of cover glasses each secured on each light receiving surface for each solar battery cell or to each light receiving surface for each solar battery array by using a transmissive adhesive, and a plastic sheet secured to a back surface opposite to the light receiving surface of the solar battery cell or the light receiving surface of the solar battery array by using an adhesive, for serving as a support for the solar battery module, difference in coefficient of thermal expansion between the plastic sheet and the cover glass being equal to or lower than 1 ppm/K.

In the solar battery module above, preferably, the plastic sheet is a carbon fiber reinforced plastic sheet obtained by impregnating with resin, one web obtained by weaving warps and wefts made of carbon fibers.

In the solar battery module above, preferably, the cover glasses are arranged at a distance from each other.

In the solar battery module above, preferably, the plastic sheet has insulating films stacked on its respective opposing surfaces, and difference in coefficient of thermal expansion between the insulating films is equal to or lower than 1 ppm/K.

In the solar battery module above, preferably, the insulating film is coated with an inorganic oxide film.

In the solar battery module above, preferably, the cover glass has an end surface treated with laser cutting or chemical etching.

According to the present invention, since deformation of a solar battery module with varying ambient temperature attributed to absence of a honeycomb plate can be prevented, it is not necessary to employ a honeycomb plate as in the conventional example. Therefore, a solar battery module achieving reduction in size and weight and having flexibility can be provided.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a cross-sectional view schematically showing a stack structure of a solar battery module according to a first embodiment.
Fig. 2 is a schematic cross-sectional view of a solar battery cell in Fig. 1.
Fig. 3 is a plan view showing a light receiving surface side of the solar battery cell in Fig. 1.
Fig. 4 is a plan view showing one example of the light receiving surface side of the solar battery module according to the first embodiment.
Fig. 5 is a plan view showing one example of a light receiving surface side of a solar battery module according to a second embodiment.
Fig. 6 is a cross-sectional view schematically showing a stack structure of a solar battery module according to a third embodiment.

### DESCRIPTION OF THE PREFERRED EMBODIMENTS

An embodiment of the present invention will be described hereinafter. In the drawings of the present invention, the same or corresponding elements have the same reference characters allotted.

### (First Embodiment)

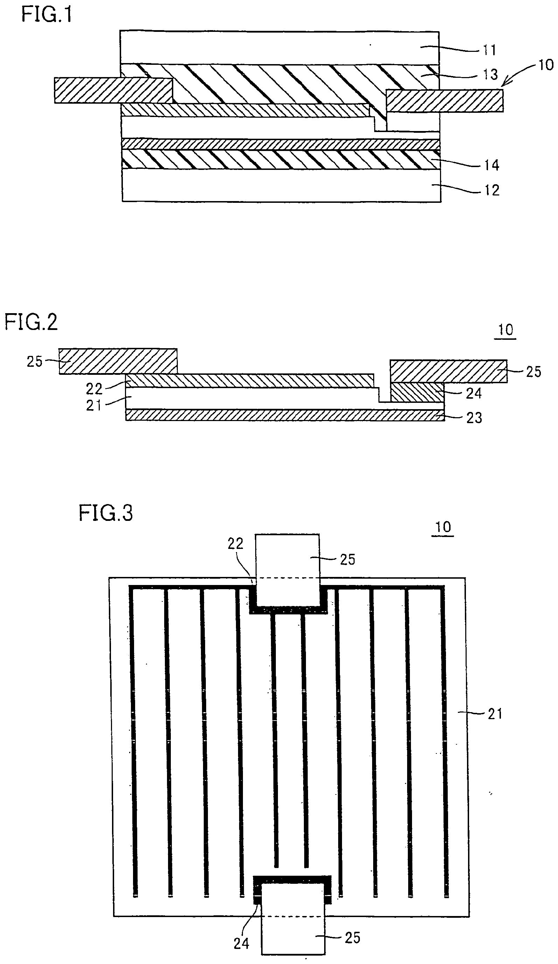

Fig. 1 shows a schematic cross-sectional view of a stack structure of a solar battery module according to a first embodiment. The solar battery module according to the first embodiment is a solar battery module formed by connecting a plurality of solar battery cells having flexibility to one another. It is noted that Fig. 1 shows only a part of one solar battery cell.

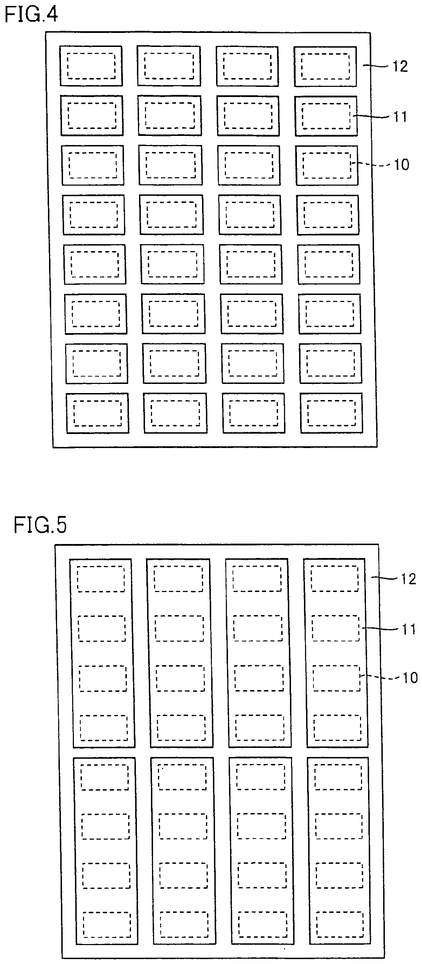

As shown in Fig. 1, in the solar battery module according to the present embodiment, a cover glass 11 is secured to a light receiving surface (on an upper side in the drawing) of a solar battery cell 10 having flexibility, with the use of a transmissive adhesive 13. In addition, a plastic sheet 12 serving as a support is secured to a back surface which is a surface opposite to the light receiving surface of solar battery cell 10, with the use of an adhesive 14. Namely, a plurality of solar battery cells 10 electrically connected to one another through interconnectors are arranged on one plastic sheet 12, and cover glass 11 is individually secured onto each solar battery cell 10, by using transmissive adhesive 13 (see Fig. 4).

As shown in Fig. 2, in solar battery cell 10, a first electrode 22 is formed on one surface (light receiving surface) of a photoelectric conversion layer 21 having one or more pn junctions, and a metal thin film 23 serving as a back electrode is formed on an opposite surface (back surface). In addition, a second electrode 24 is formed at a position on a surface of photoelectric conversion layer 21 facing the same direction as the surface where first electrode 22 is formed, with a pn junction not being interposed between photoelectric conversion layer 21 and metal thin film 23.

An interconnector 25 is electrically connected to each upper surface of first electrode 22 and second electrode 24, and each interconnector 25 is electrically connected to another not-shown adjacent solar battery cell 10. As shown in Fig. 3, though first electrode 22 preferably has a shape like a comb, the shape is not limited as such, and all electrode shapes allowing a function as a photoelectric conversion device can be adopted.

Photoelectric conversion layer 21 can be fabricated, for example, by epitaxially growing a group III-V compound semiconductor such as InGaP and GaAs on a semiconductor substrate such as a Ge substrate or a GaAs substrate and thereafter separating the semiconductor substrate and the epitaxially grown photoelectric conversion layer from each other. In order for solar battery cell 10 to have good flexibility, photoelectric conversion layer 21 preferably has a thickness not greater than 50 µm.

First electrode 22, metal thin film 23, second electrode 24, and interconnector 25 are formed with known techniques, respectively. Interconnector 25 can readily electrically be connected to first electrode 22 and second electrode 24, in particular through parallel gap welding. In some cases, a resin film for protection such as polyimide may further be bonded onto a surface of metal thin film 23. In order to maintain flexibility of solar battery cell 10, metal thin film 23 preferably has a thickness not greater than 100 µm.

Referring back to Fig. 1, plastic sheet 12 provided on the back surface side of solar battery cell 10 functions as a support for supporting a structure of the solar battery module having a plurality of solar battery cells 10. Since plastic sheet 12 has flexibility, the solar battery module in which a plurality of solar battery cells 10 having flexibility are arranged on plastic sheet 12 can exhibit good flexibility. In order to exhibit better flexibility, plastic sheet 12 preferably has a thickness not greater than 500 µm.

In the present embodiment, plastic sheet 12 functioning as the support should have a coefficient of thermal expansion close to that of cover glass 11. More specifically, difference in coefficient of thermal expansion between plastic sheet 12 and cover glass 11 is equal to or lower than 1 ppm/K. The reason is as follows.

Namely, the present inventor confirmed that a solar battery module significantly warps in an environment at high temperature and at low temperature in a case where a solar battery cell having flexibility is mounted on a support having flexibility. Then, the present inventor found that, in a conventional solar battery module including a honeycomb plate having high rigidity, even though layers forming a stack structure are different from one another in warpage, the stack structure was maintained because rigidity of the honeycomb plate was dominant, whereas the solar battery module having a construction in Fig. 1 cannot maintain its shape. Then, the present inventor's continued studies determined that deformation of the solar battery module can be prevented by the fact that cover glass 11 which is an outermost layer on the light receiving surface side of the stack structure and plastic sheet 12 serving as the support on the back surface side are close to each other in coefficient of thermal expansion, and thus the present inventor completed the present invention.

When difference in coefficient of thermal expansion between plastic sheet 12 and cover glass 11 exceeds 1 ppm/K in solar battery cell 10, thermal stress caused by the difference in warpage between plastic sheet 12 and cover glass 11 becomes great, which leads to breakage of the solar battery module. In consideration of use of the solar battery module in the space, the difference in value of the coefficient of thermal expansion should be equal to or lower than 1 ppm/K as described above, however, tolerance for the difference in value of the coefficient of thermal expansion can be broadened depending on a range of an actual operating temperature. Naturally, however, in terms of ensured long-term reliability, it is important to match the coefficient of thermal expansion of plastic sheet 12 with the coefficient of thermal expansion of cover glass 11 as much as possible.

A carbon fiber reinforced plastic sheet (hereinafter also referred to as a "CFRP sheet") can be employed as plastic sheet 12. An exemplary CFRP sheet includes a stack type CFRP sheet obtained by impregnating carbon fibers aligned in one direction with such a resin as epoxy or polycyanate, layering a plurality of prepreg sheets in which resin has partially been cured such that their directions of fibers are alternately orthogonal to one another, and then fully curing the resin. Such a CFRP sheet can isotropically exhibit such characteristics as modulus of elasticity in tension and tensile strength.

In addition, a single-layered CFRP sheet obtained by impregnating one web in which warps and wefts made of carbon fibers have been woven with resin may be employed as plastic sheet 12. This single-layered CFRP sheet can be formed, for example, by fabricating one web by plain-weaving or twilling warps and wefts made of carbon fibers, impregnating the web with such a resin as epoxy or polycyanate, and then fully curing the resin. Since the single-layered CFRP sheet thus fabricated is lower in ratio of impregnation with resin than the stack type CFRP sheet described above, reduction in weight and thickness can be achieved and hence further reduction in weight and size of the solar battery module can be achieved.

In order to protect the module against ultraviolet rays and radioactive rays, borosilicate glass to which cerium has been added is preferably employed for cover glass 11, and from a point of view of flexibility and reduction in weight, cover glass 11 preferably has a thickness around 50 µm. In addition, for the purpose of prevention of reflection, a secondary coating such as an inorganic oxide film coating or a magnesium fluoride coating may be provided on an outermost surface of cover glass 11. Further, an end surface of cover glass 11 is preferably subjected to end surface treatment such as chemical etching or laser cutting. As a result of end surface treatment, defects in the end surface of the glass are eliminated, which leads to improvement in quality of cover glass 11 and improvement in reliability of the solar battery module against glass cracking due to an external factor in an actual environment of use.

A size of cover glass 11 is not particularly restricted, however, cover glasses are preferably individually provided on respective light receiving surfaces of a plurality of solar battery cells 10 connected to one another in series and in parallel, as shown in Fig. 4, so that flexibility of the solar battery module is improved. Further, since solar battery cells 10 having cover glasses 11 arranged can be handled as one unit in a manufacturing process, each unit can easily be placed on plastic sheet 12 in a stable manner. In addition, since bonding is carried out for each unit, even when any solar battery cell 10 fails during the process, such failure in the solar battery module can be overcome by exchanging one unit. It is noted that Fig. 4 does not show an interconnector, a bus bar, and the like.

In a case where a large sheet of glass is placed on a large module, when the glass is broken due to an external factor during the process or in an environment where the solar battery module is actually used, even a single crack leads to cracking of the glass across the module. In contrast, in a case where the cover glass is divided into a plurality of pieces, even when a crack is developed in one of them, the crack of the glass is confined only in one unit and hence cracking of the glass can be prevented from developing across the entire module.

In addition, as shown in Fig. 4, cover glasses 11 are preferably provided on solar battery cells 10 at a distance from each other. By thus providing a spatial distance (interval) between cover glasses 11, even in a case where plastic sheet 12 is subjected to heavy vibration and temporarily bent, rubbing of the end surfaces of adjacent cover glasses 11 against each other can be prevented. If the end surfaces of cover glasses 11 rub against each other and a small flaw is caused in the end surface, a crack in the glass may develop from that portion. By providing an interval between cover glasses 11, however, reliability of the solar battery module according to the present embodiment can be improved. In order to improve reliability by further efficiently suppressing the damage above, the interval above is preferably not smaller than double the thickness of cover glass 11.

A silicone adhesive less in gas emission in a space environment can be employed for transmissive adhesive 13. In addition, a silicon adhesive manufactured for applications in the space can suitably be employed for adhesive 14 securing the back surface of solar battery cell 10 and the CFRP sheet to each other, as in the case of adhesive 13. It is noted that adhesive 14 does not have to have transmissive property and hence a colored low-transmissive or non-transmissive adhesive may be employed.

In the present embodiment, in the solar battery module having the solar battery cells having flexibility, difference in coefficient of thermal expansion between cover glass 11 provided on the light receiving surface side of the solar battery cell and plastic sheet 12 provided on the back surface side of solar battery cell 10 is equal to or lower than 1 ppm/K. According to such a feature, it is not necessary to include a honeycomb plate as in the conventional example. In addition, deformation of the solar battery module with varying ambient temperature, attributed to absence of the honeycomb plate, can be prevented. Therefore, reduction in size and weight of the solar battery module can be achieved. Thus, for example, cost for launching an artificial satellite can significantly be reduced.

Further, by employing the single-layered CFRP sheet described above instead of the stack type CFRP sheet as plastic sheet 12, further reduction in size and weight of the solar battery module can be achieved. Furthermore, by individually providing cover glass 11 on each light receiving surface of each solar battery cell 10, further reduction in weight of the solar battery can be achieved and replacement of a damaged portion is facilitated.

Moreover, by providing an interval between cover glasses 11, possibility of breakage of cover glass 11 can be lowered and hence reliability of the solar battery module can be improved. In addition, by subjecting the end surface of cover glass 11 to end surface treatment, reliability of the solar battery module can further be improved. In a case where a plurality of solar battery cells are connected to one another, a diode serving as a protective element is arranged between the solar battery cells connected in series or in parallel so that breakage of the entire solar battery module can be prevented.

### (Second Embodiment)

A solar battery module according to a second embodiment is a solar battery module having flexibility, in which a cover glass is individually provided on each light receiving surface of a solar battery array in which a plurality of solar battery cells having flexibility are connected to one another. Since the structure of solar battery cell 10 and the stack structure of the solar battery module in the present embodiment are the same as those in the first embodiment, description thereof will not be repeated.

Fig. 5 is a plan view showing one example of a light receiving surface side of the solar battery module according to the second embodiment, and shows the solar battery module having the solar battery arrays. The solar battery array refers to a unit constituted of a plurality of solar battery cells electrically connected to one another through interconnectors and containing two or more solar battery cells. For example, by connecting a plurality of solar battery arrays in series or in parallel to a bus bar, a large solar battery module can be formed.

In Fig. 5, the solar battery array constituted of four solar battery cells 10 arranged on plastic sheet 12 is covered with individual cover glass 11. It is noted that Fig. 5 does not show an interconnector, a bus bar, and the like.

In making the solar battery module larger, it is possible to place a large number of solar battery arrays having flexibility on a large cover glass and a plastic sheet by using an adhesive at once. With such a method, however, it is likely that a solar battery cell having flexibility is damaged during the process. In addition, if even a single array among the large number of solar battery arrays is damaged, the entire solar battery module should be replaced. Moreover, flexibility is lowered due to rigidity of the cover glass. Therefore, in the first embodiment, a case where cover glass 11 is provided individually on each light receiving surface of each solar battery cell 10 has been described by way of example. In this case, however, many cover glasses 11 are required.

Then, in the solar battery module according to the present embodiment, cover glass 11 is arranged individually for each solar battery array in which a plurality of solar battery cells are connected to one another. According to this construction, each solar battery array can individually be protected for each cover glass 11 and each solar battery array having each cover glass 11 arranged can constitute each individual unit. Since the solar battery array having cover glass 11 arranged can be handled as one unit during the manufacturing process, each unit can easily be placed on plastic sheet 12 in a stable manner.

In addition, as compared with a case where cover glass 11 is individually arranged on each solar battery cell 10, the number of cover glasses 11 used can be decreased and hence the number of manufacturing steps can be reduced. Moreover, the solar battery arrays can electrically be connected to one another, for example, through a bus bar, and the unit consisting of such a single solar battery array can more readily be removed from the solar battery module.

As shown in Fig. 5, cover glasses 11 are preferably provided on the solar battery arrays at a distance from each other. By thus providing a spatial distance (interval) between cover glasses 11, even in a case where plastic sheet 12 is subjected to heavy vibration and temporarily bent, rubbing of the end surfaces of adjacent cover glasses 11 against each other can be prevented. If the end surfaces of cover glasses 11 rub against each other and a small flaw is caused in the end surface, a crack in the glass may develop from that portion. By providing an interval between cover glasses 11, however, reliability of the solar battery module according to the present embodiment can be improved. In order to improve reliability by further efficiently suppressing the damage above, the interval above is preferably not smaller than double the thickness of cover glass 11.

In the present embodiment, in the solar battery module having the solar battery arrays having flexibility, difference in coefficient of thermal expansion between cover glass 11 provided on the light receiving surface side of the solar battery array and plastic sheet 12 provided on the back surface side of the solar battery array is equal to or lower than 1 ppm/K. According to such a feature, it is not necessary to include a honeycomb plate as in the conventional example. In addition, deformation of the solar battery module with varying ambient temperature, attributed to absence of the honeycomb plate, can be prevented. Therefore, reduction in size and weight of the solar battery module can be achieved.

### (Third Embodiment)

A solar battery module according to a third embodiment is a solar battery module having flexibility, in which insulating films are stacked on respective opposing surfaces of a plastic sheet. Since the structure of solar battery cell 10 in the present embodiment is the same as that in the first embodiment, description thereof will not be repeated.

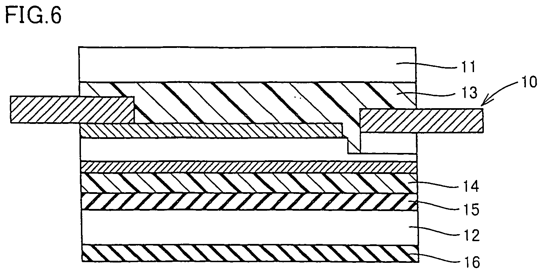

Fig. 6 shows a schematic cross-sectional view of a stack structure of the solar battery module according to the third embodiment. In Fig. 6, insulating films 15 and 16 are stacked on respective opposing surfaces of plastic sheet 12. Since the construction other than insulating films 15 and 16 stacked on respective opposing surfaces of plastic sheet 12 is the same as that of the solar battery module having the solar battery cells according to the first embodiment or the solar battery module having the solar battery arrays according to the second embodiment, description thereof will not be repeated.

When a conductive carbon fiber protrudes from an impregnation resin in plastic sheet 12 or when solar battery cell 10 and a carbon fiber are in direct contact with each other due to non-uniformly applied adhesive 14, conduction through a carbon fiber between solar battery cells 10 may occur and a function of the solar battery module may be lowered.

In the present embodiment, insulating films 15 and 16 are stacked on respective opposing surfaces of plastic sheet 12. A Kapton® film represents one example of insulating films 15 and 16. As a method of placing insulating films 15 and 16 on plastic sheet 12, a method of impregnating a carbon fiber with a resin and placing insulating films 15 and 16 on the respective opposing surfaces for adhesion in thermosetting a prepreg sheet in which resin has partially been cured at a high temperature around 180°C is available.

Here, if an insulating film is to be provided on plastic sheet 12 only for insulation, it is not necessary to place insulating film 16 and arrangement of insulating film 15 between plastic sheet 12 and adhesive 14 suffices. If insulating film 15 is bonded only to one surface of plastic sheet 12, however, significant warpage is caused when a formed product which is a stack of insulating film 15 and plastic sheet 12 returns to a room temperature, due to difference in coefficient of thermal expansion between the prepreg sheet and insulating film 15 at the time of curing.

Therefore, in the present embodiment, it is important to place the insulating films on respective opposing surfaces of plastic sheet 12. Difference in coefficient of thermal expansion between insulating films 15 and 16 should only be not higher than 1 ppm/K, and films may be different in type. In addition, in a case where insulating films 15 and 16 are provided on respective opposing surfaces of plastic sheet 12, difference in coefficient of thermal expansion between the entire stack constituted of insulating film 15, plastic sheet 12, and insulating film 16 and cover glass 11 should be not higher than 1 ppm/K.

Further, insulating film 15, 16 is preferably coated with an inorganic metal oxide film. By forming an inorganic metal oxide film on a surface of insulating film 15, 16, plastic sheet 12 can be protected against highly reactive atomic oxygen present in a space environment. Examples of the inorganic metal oxide film include SiO₂, Al₂O₃, ZnO, ITO, and the like.

In the present embodiment, the solar battery module having solar battery arrays having flexibility can achieve reduction in size and weight and suppressed damage of plastic sheet 12. Therefore, a solar battery module having small size, light weight and high reliability can be provided.

Though each embodiment has been described above, the present invention may be implemented by combining the embodiments described above as appropriate.

### Examples

The present invention will more specifically be described with reference to Example and Comparative Examples, however, the present invention is not limited thereto.

### (Example 1)

Initially, an n-type GaAs layer was formed on a p-type Ge substrate doped with Ga. Here, As in the n-type GaAs layer diffused into the p-type Ge substrate and an n-type Ge layer was formed in the surface of the p-type Ge substrate. Then, photoelectric conversion layer 21 having at least one pn junction was formed on the p-type Ge substrate by epitaxially growing on the n-type GaAs layer, an n-type InGaP layer, a p-type AlGaAs layer, a p-type InGaP layer, a p-type GaAs layer, an n-type GaAs layer, an n-type AlInP layer, an n-type InGaP layer, a p-type AlGaAs layer, a p-type AlInP layer, a p-type InGaP layer, an n-type InGaP layer, an n-type AlInP layer, an n-type GaAs layer in this order. Here, photoelectric conversion layer 21 as a whole had a thickness of 4 µm.

Then, first electrode 22 constituted of a rectangular portion of 2.7 mm wide × 0.85 mm long and comb-shaped portions connected to this rectangular portion was formed by vapor-depositing an Au-Ge film, an Ni film, an Au film, and an Ag film in this order on the surface of the n-type GaAs layer serving as an outermost surface of photoelectric conversion layer 21, followed by heat treatment.

Then, second electrode 24 was formed by removing a part of photoelectric conversion layer 21 with alkaline and acid etchants and vapor depositing an Au film and an Ag film in this order on the exposed surface of photoelectric conversion layer 21 (at a position on a surface of photoelectric conversion layer 21 facing the same direction as the surface where first electrode 22 is formed, with a pn junction not being interposed between photoelectric conversion layer 21 and metal thin film 23), followed by heat treatment.

Thereafter, after the p-type Ge substrate was separated from photoelectric conversion layer 21, metal thin film 23 serving as the back electrode was formed on the back surface opposite to the side of photoelectric conversion layer 21 where first electrode 22 and second electrode 24 were formed, and a rectangular plate of 70 mm wide × 35 mm long was cut out. Then, interconnector 25 was connected to each surface of first electrode 22 and second electrode 24 through parallel gap welding, to thereby fabricate solar battery cell 10. Five solar battery cells 10 were fabricated with the similar method.

Five fabricated solar battery cells 10 were aligned in series in the same direction, a silicon adhesive less in gas emission was applied to this light receiving surface side (the side where first electrode 22 and second electrode 24 were formed), and cover glass 11 of 185 mm long × 80 mm wide × 50 µm thick was bonded. Borosilicate glass having a coefficient of thermal expansion of 3.8 ppm/K, to which cerium had been added, was employed for cover glass 11.

Thereafter, interconnectors 25 for solar battery cells 10, adjacent to each other, were connected to each other by welding, a silicone resin less in gas emission was applied to the back surface side of solar battery cell 10, and thus plastic sheet 12 of 200 mm long × 80 mm wide × 110 µm thick was bonded. A CFRP sheet having a coefficient of thermal expansion of 3 ppm/K was employed for plastic sheet 12.

Through the steps above, the solar battery module in which five solar battery cells 10 were connected to one another was completed. It is noted that a distance between cover glass 11 and plastic sheet 12 here, that is, a thickness of the structure constituted of adhesive 13, solar battery cell 10 and adhesive 14, was 70 µm.

The fabricated solar battery module was observed in an environment where an atmospheric temperature varied from -100°C to 100°C, and then no warpage was visually observed. In Example 1, though difference in coefficient of thermal expansion between cover glass 11 and plastic sheet 12 was 0.8 ppm/K, even when the difference was 1 ppm/K, a radius of curvature of warpage of the solar battery module when the temperature was high (+100°C) and when the temperature was low (-100°C) was approximately 2.0 m, and warpage was substantially ignorable in a module having a long side around 185 mm.

In a case where the solar battery module was made larger, for example, even in a module having a long side of 1 m, the long side portion merely became an arc at an angle of approximately 29° at the maximum so long as the radius of curvature was not greater than 2.0 m, which was also understood to give rise to no problem in use.

### (Comparative Example 1)

A solar battery module was fabricated with a method the same as in Example 1, except for employing glass having a coefficient of thermal expansion of 6 ppm/K as cover glass 11. The fabricated solar battery module was observed in an environment where an atmospheric temperature varied from -100°C to 100°C, and then great warpage of a radius of curvature of approximately 67 cm was observed when the temperature was high (+100°C) and when the temperature was low (-100°C). This warpage was caused due to difference in dimension between cover glass 11 and plastic sheet 12 at each temperature caused by difference in coefficient of thermal expansion between cover glass 11 and plastic sheet 12.

In a case where the solar battery module was made larger, for example, in a module having a long side of 1 m, with a radius of curvature of 67 cm, the long side portion became an arc at an angle of approximately 86° at the maximum. Therefore, stress due to thermal stress provided to the solar battery cell becomes high and practical use seems to be difficult.

### (Comparative Example 2)

A solar battery module was fabricated with a method the same as in Example 1, except for employing a polyimide film instead of a CFRP sheet as plastic sheet 12. The polyimide film had a coefficient of thermal expansion of 12 ppm/K. The fabricated solar battery module was observed in an environment where an atmospheric temperature varied from -100°C to 100°C. Then, a degree of change in shape of the solar battery module was too great when the temperature was high and when the temperature was low, which led to the problem of breakage of the cover glass and the solar battery cell.

Based on the results above, it is considered that, in a solar battery module for an artificial satellite required to have long-term reliability, change in shape due to thermal stress results in application of stress to a solar battery cell and wiring around the same and that it is important to substantially match the coefficient of thermal expansion of the cover glass with that of the support.

Though the embodiments and the example of the present invention have been described above, combination of features in the embodiments and the example as appropriate is also originally intended.

Although the present invention has been described and illustrated in detail, it is clearly understood that the same is by way of illustration and example only and is not to be taken by way of limitation, the scope of the present invention being defined by the terms of the appended claims.

## Claims

1. A solar battery module including a plurality of solar battery arrays in which solar battery cells (10) having flexibility are electrically connected to one another through interconnectors (25), comprising:
a plurality of cover glasses (11) each secured on each light receiving surface for each said solar battery cell (10) or to each light receiving surface for each said solar battery array by using a transmissive adhesive (13); and
a plastic sheet (12) secured to a back surface opposite to said light receiving surface of said solar battery cell (10) or said light receiving surface of said solar battery array by using an adhesive (14), for serving as a support for said solar battery module, the difference in coefficient of thermal expansion between said plastic sheet (12) and said cover glass (11) being equal to or lower than 1 ppm/K.

2. The solar battery module according to claim 1, wherein
said plastic sheet (12) is a carbon fiber reinforced plastic sheet obtained by impregnating with resin, one web obtained by weaving warps and wefts made of carbon fibers.

3. The solar battery module according to claim 1, wherein
said cover glasses (11) are arranged at a distance from each other.

4. The solar battery module according to claim 1, wherein
said plastic sheet (12) has insulating films (15, 16) stacked on its respective opposing surfaces, and difference in coefficient of thermal expansion between said insulating films (15, 16) is equal to or lower than 1 ppm/K.

5. The solar battery module according to claim 1, wherein
said insulating film (15, 16) is coated with an inorganic oxide film.

6. The solar battery module according to claim 1, wherein
said cover glass (11) has an end surface treated with laser cutting or chemical etching.

## Patentansprüche

1. Solarbatteriemodul, das eine Vielzahl von Solarbatterie-Arrays enthält, in denen Solarbatteriezellen (10) mit Flexibilität durch Verbindungsleitungen (25) miteinander elektrisch verbunden sind, umfassend:
eine Vielzahl von Deckgläsern (11), die jeweils auf jeder lichtempfangenden Oberfläche für jede Solarbatteriezelle (10) oder mit jeder lichtempfangenden Oberfläche für jedes Solarbatterie-Array unter Verwendung eines durchlässigen Klebstoffs (13) befestigt sind; und
eine Kunststoffplatte (12), die an einer Rückseite, die der lichtempfangenden Oberfläche der Solarbatteriezelle (10) oder der lichtempfangenden Oberfläche des Solarbatterie-Arrays gegenüberliegt, unter Verwendung eines Klebstoffs (14) befestigt ist, um als ein Träger für das Solarbatteriemodul zu dienen,
wobei die Differenz im thermischen Expansionskoeffizienten zwischen der Kunststoffplatte (12) und dem Deckglas (11) kleiner oder gleich 1 ppm/K ist.

2. Solarbatteriemodul nach Anspruch 1, wobei
die Kunststoffplatte (12) eine kohlenstofffaserverstärkte Kunststoffplatte ist, die durch Imprägnieren mit einem Harz erhalten wird, wobei ein Gewebe durch Weben von aus Kohlenstofffasern bestehenden Kett- und Schussfäden erhalten wird.

3. Solarbatteriemodul nach Anspruch 1, wobei
die Deckgläser (11) in einer Distanz voneinander angeordnet sind.

4. Solarbatteriemodul nach Anspruch 1, wobei
die Kunststoffplatte (12) isolierende Filme (15, 16) aufweist, die auf ihren jeweiligen gegenüberliegenden Oberflächen gestapelt sind, und eine Differenz im thermischen Expansionskoeffizienten zwischen den isolierenden Filmen (15, 16) kleiner oder gleich 1 ppm/K ist.

5. Solarbatteriemodul nach Anspruch 1, wobei
der isolierende Film (15, 16) mit einem anorganischen Oxidfilm beschichte ist.

6. Solarbatteriemodul nach Anspruch 1, wobei
das Deckglas (11) eine mit Laserschneiden oder einer chemischen Ätzung behandelte Endoberfläche aufweist.

## Revendications

1. Module de batteries solaires contenant plusieurs ensembles de batteries solaires dans lesquels des éléments de batteries solaires (10) présentant une flexibilité sont reliés électriquement entre eux par des éléments d'interconnexion (25), comprenant :
plusieurs verres de recouvrement (11) qui sont fixés chacun sur chaque surface de réception de lumière pour chaque cellule de batterie solaire (10) ou à chaque surface de réception de lumière pour chaque ensemble de batteries solaires à l'aide d'un adhésif transmissif (13) ; et
une feuille de plastique (12) fixée à une surface arrière opposée à la surface de réception de lumière de la cellule de batterie solaire (10) ou à la surface de réception de lumière de l'ensemble de batteries solaires à l'aide d'un adhésif (14), pour servir de support pour le module de batterie solaire,
la différence de coefficient de dilatation thermique entre la feuille de plastique (12) et le verre de recouvrement (11) étant égale ou inférieure à 1 ppm/K.

2. Module de batteries solaires selon la revendication 1, dans lequel la feuille de plastique (12) est une feuille de plastique renforcée par des fibres de carbone, obtenue en imprégnant de résine une toile obtenue par tissage de chaînes et de trames composées de fibres de carbone.

3. Module de batteries solaires selon la revendication 1, dans lequel les verres de recouvrement (11) sont disposés à une certaine distance les uns des autres.

4. Module de batteries solaires selon la revendication 1, dans lequel la feuille de plastique (12) comporte des films isolants (15, 16) empilés sur leurs surfaces opposées respectives, et la différence de coefficient de dilatation thermique entre les films isolants (15, 16) est égale ou inférieure à 1 ppm/K.

5. Module de batteries solaires selon la revendication 1, dans lequel le film isolant (15, 16) est revêtu d'un film d'oxyde inorganique.

6. Module de batteries solaires selon la revendication 1, dans lequel le verre de recouvrement (11) a une surface d'extrémité traitée par découpage au laser ou gravure chimique.
